# EUROPÄISCHE PATENTSCHRIFT

(11) **EP 3 051 552 B1**
(45) Veröffentlichungstag und Bekanntmachung des Hinweises auf die Patenterteilung: **21.10.2020**
(21) Anmeldenummer: 15196258.6
(22) Anmeldetag: 25.11.2015
(51) Int. Cl.: H01H 27/00, F16P 3/08, H03K 17/945

(54) **FUNKTIONSMODUL MIT EINEM GEHÄUSE**
FUNCTIONAL MODULE WITH A HOUSING
MODULE FONCTIONNEL DOTE D'UN BOITIER

(30) Priorität: 27.01.2015 DE 102015101132
(43) Veröffentlichungstag der Anmeldung: 03.08.2016
(73) Patentinhaber: EUCHNER GmbH + Co. KG, 70771 Leinfelden-Echterdingen (DE)
(72) Erfinder: Gehrke, Mike, 73269 Hochdorf (DE)
(74) Vertreter: Ruckh, Rainer Gerhard

(56) Entgegenhaltungen:
- EP-A2- 2 650 993
- DE-U1- 9 013 198
- US-B1- 6 310 305
- Euchner Gmbh: "Betriebsanleitung Sicherheitssysteme", , 3. Januar 2015 (2015-01-03), XP055278921, Gefunden im Internet: URL:https://www.euchner.de/portals/0/siriu smedia/pim/data/210579.pdf [gefunden am 2016-06-08]

## Beschreibung

Die Erfindung betrifft ein Funktionsmodul gemäß dem Oberbegriff des Anspruchs 1.

Funktionsmodule der in Rede stehenden Art bilden generell Elektronikmodule, welche vorgegebene Funktionalitäten aufweisen.

Beispielsweise können derartige Funktionsmodule Bestandteile von Sicherheitssystemen wie insbesondere Sicherheitszuhaltesystemen sein. Ein derartiges System ist beispielsweise von dem Sicherheitssystem MGB der Firma Euchner gebildet. Dieses Sicherheitssystem gewährleistet ein sicheres Zuhalten von beweglich trennenden Schutzeinrichtungen, insbesondere Schutztüren, und somit einen gesicherten Zugang zu eingezäunten sicherheitskritischen Gefahrenbereichen.

Dieses Sicherheitszuhaltesystem umfasst ein Zuhaltemodul, an welchem ein Griffmodul angeordnet ist. Diese Module dienen zum sicheren Zuhalten der Schutztür. Der Türdrücker des Griffmoduls kann durch Federkraft in zugehaltener Stellung gehalten werden und durch Magnetkraft entsperrt werden. Alternativ kann der Türdrücker durch Magnetkraft in zugehaltener Stellung gehalten werden und durch Federkraft entsperrt werden.

Das Zuhaltemodul kann in seiner Funktionalität dadurch erweitert sein, dass dieses zusätzliche Submodule wie zum Bespiel ein Tastenmodul als Bedieneinheit aufweist.

Ein erster Nachteil eines solchen Sicherheitszuhaltesystems besteht darin, dass bei einem auftretenden Defekt das gesamte Sicherheitszuhaltesystem zu Reparaturzwecken an den Hersteller zurückgeschickt werden muss.

Ein weiterer Nachteil des Sicherheitszuhaltesystems besteht darin, dass der konstruktive Aufwand für eine Anpassung an unterschiedliche Konfigurationen unerwünscht hoch ist. Unterschiedliche Konfigurationen treten insbesondere durch unterschiedliche Anordnungen der Schutztür relativ zum Sicherheitszuhaltesystem auf. Je nach Anordnung der Schutztür muss eine rechtsseitige oder linksseitige Anordnung des Griffmoduls am Zuhaltemodul vorgesehen sein. Um diese Konfigurationen abdecken zu können, müssen unterschiedliche Varianten des Zuhaltemoduls vorgesehen werden, die verschiedene Konstruktionen für eine rechts- oder linksseitige Befestigung des Griffmoduls aufweisen.

Die US 6 310 305 B1 betrifft eine Sicherheitsschalteranordnung mit einem Schalterkörper und einem Verschlusskörper, der eine Öffnung zur Aufnahme eines Aktuators aufweist. Der Schalterkörper und der Verschlusskörper befinden sich in einer Wand, die eine Gebäudeöffnung begrenzt, welche mit einer Tür abschließbar ist. An der Tür befindet sich der Aktuator. Durch Einführungen des Aktuators in die Öffnung des Verschlusskörpers kann die Tür im geschlossenen Zustand verriegelt werden.

Die DE 90 13 196 U1 betrifft einen Sicherheitsschalter für Schutzabdeckungen mit einem Gehäuse, das mindestens drei im Bereich eines verstellbaren Schaltgliedes vorgesehene, erste Öffnungen an drei Seiten für einen durch sein Einführen in eine der Öffnungen bzw. sein Herausziehen aus der Öffnung einen Schaltvorgang auslösenden, ersten Betätiger aufweist. Zusätzlich sind drei zweite, zusammenlaufende Öffnungen benachbart und auf den Seiten der ersten Öffnungen vorgesehen, in die ein zweiter Betätiger einführbar ist, wobei die zweiten Öffnungen einen gemeinsamen Bereich besitzen, in den ein mit einem Elektromagnet gekoppelter, durch Betätigung des Elektromagneten zurückziehbarer Sperrstift für den zweiten Betätiger federvorgespannt ragt.

Die EP 2 650 993 A2 betrifft ein Gehäuse, welches eine Steuereinrichtung zur Ausführung einer elektronischen Funktion beinhaltet, sowie ein Basismodul, das zur Befestigung des Gehäuses für eine vorbestimmte Montagesituation ausgebildet ist. Das Gehäuse und das Basismodul sind für eine feste aber lösbare Verbindung ausgebildet. Damit ist in Abhängigkeit von der Montagesituation das Gehäuse mit einem an die jeweilige Montagesituation angepassten Basismodul verbindbar. Das Basismodul ist als Installationskasten mit einer Sammelschiene ausgeführt, wodurch eine geringe Bauhöhe erzielt werden kann.

In WO 90/07814 A1 ein elektrischer Steckverbinder in einem Netzwerk beschrieben, welcher eine Buchse und einen Stecker aufweist.

In Euchner GmbH: "Betriebsanleitung Sicherhheitssysteme", 3. Januar 2015 sind Sicherheitszuhaltesysteme beschrieben, die jeweils ein Zuhaltemodul aufweisen.

Der Erfindung liegt die Aufgabe zugrunde, ein Funktionsmodul der eingangs genannten Art bereitzustellen, welches bei einem konstruktiv einfachen Aufbau eine hohe Funktionalität aufweist.

Zur Lösung dieser Aufgabe sind die Merkmale des Anspruchs 1 vorgesehen. Vorteilhafte Ausführungsformen und zweckmäßige Weiterbildungen der Erfindung sind in den abhängigen Ansprüchen beschrieben.

Die Erfindung betrifft ein Funktionsmodul mit einem Gehäuse, wobei das Gehäuse wenigstens eine Aufnahme für ein Submodul ausgebildet. Das Funktionsmodul ist Bestandteil eines Sicherheitszuhaltesystems. Das Submodul ist in zwei unterschiedlichen Drehpositionen in der Aufnahme montierbar. Das Submodul weist drehinvariante elektrische Anschlussmittel derart auf, dass diese in den beiden Drehpositionen des Submoduls in identischer Weise mit elektrischen Anschlussmitteln im Gehäuse des Funktionsmoduls kontaktiert werden können. Das Funktionsmodul ist ein Zuhaltemodul eines Sicherheitssystems, wobei am Gehäuse des Zuhaltemoduls eine seitlich ausmündende Riegel-Aufnahme für ein Griffmodul vorgesehen ist, in einer ersten Drehposition des Zuhaltemoduls an der Riegel-Aufnahme ein rechtsseitiges Griffmodul montierbar. In einer um 180° bezüglich der ersten Drehposition gedrehten zweiten Drehposition des Zuhaltemoduls ist an der Riegel-Aufnahme ein linksseitiges Griffmodul fixierbar.

Ein erster wesentlicher Vorteil der Erfindung besteht darin, dass die Submodule des Funktionsmoduls als unabhängige Elemente am Funktionsmodul einfach montiert und bei Bedarf an diesem getauscht werden können. Dies führt insbesondere zu einer erheblichen Reduzierung des Aufwands bei Reparaturen, da beispielsweise bei einem Defekt eines Submoduls nur dieses ausgetauscht werden muss.

Ein weiterer wesentlicher Vorteil der Erfindung besteht darin, dass durch die Möglichkeit der Anbringung des oder der Submodule in unterschiedlichen Drehpositionen am Funktionsmodul mit geringem Aufwand unterschiedliche Konfigurationen des Funktionsmoduls realisiert werden, wodurch eine besonders einfache Anpassung an unterschiedliche Applikationen möglich ist.

Besonders vorteilhaft ist das Submodul in zwei um 180° gegeneinander gedrehten Drehpositionen in der Aufnahme montierbar.

Sind mehrere Submodule am Funktionsmodul vorgesehen, können zweckmäßig alle Submodule in zwei um 180° gedrehten Drehpositionen am Funktionsmodul montiert werden.

Die Montage eines Submoduls in unterschiedlichen Drehpositionen wird erfindungsgemäß dadurch ermöglicht, dass das Submodul drehinvariante elektrische Anschlussmittel derart aufweist, dass diese in den beiden Drehpositionen des Submoduls in identischer Weise mit elektrischen Anschlussmitteln im Gehäuse des Funktionsmoduls kontaktiert werden können.

Besonders vorteilhaft können die Anschlussmittel des oder der Submodule werkzeuglos mit den Anschlussmitteln des Zuhaltemoduls verbunden und wieder von diesen gelöst werden. Dadurch kann das oder jedes Submodul in den unterschiedlichen Einbaupositionen schnell und einfach elektrisch mit dem Zuhaltemodul verbunden werden.

Hierzu können die Anschlussmittel als steckbare Anschlussklemmen ausgebildet sein.

Alternativ können als Anschlussmittel Federkontakte vorgesehen sein.

Besonders vorteilhaft sind die Anschlussmittel im Gehäuse an einen Datenbus angeschlossen.

Dabei verlaufen die Busleitungen des Datenbusses in einer im Gehäuse angeordneten Leiterplatte.

Der Datenbus bildet ein internes Bussystem, mit welchem, unabhängig von externen Bussystemen, eine Kommunikation der Komponenten des Funktionsmoduls und allen Submodulen ermöglicht wird. Durch die konstruktive Ausgestaltung des Datenbusses derart, dass die Busleitungen in Leiterplatten der Module geführt sind, kann auf aufwändige Verkabelungen innerhalb des Zuhaltemoduls verzichtet werden. Dieser Vorteil wird dadurch noch verstärkt, dass die Anschlussmittel der Submodule direkt auf den Leiterplatten kontaktiert werden können.

Erfindungsgemäß ist das Funktionsmodul als Zuhaltemodul eines Sicherheitszuhaltesystems, in Form eines Sicherheitszuhaltesystems, ausgebildet. Dabei ist am Gehäuse des Zuhaltemoduls eine seitlich ausmündende Riegel-Aufnahme für ein Griffmodul vorgesehen.

Zweckmäßig weist das Zuhaltemodul als Submodul ein Anschluss-Submodul und ein Tasten-Submodul auf. Das Anschluss-Submodul dient zum Anschluss an externe Einheiten, das Tasten-Submodul weist Bedienelemente in Form von Tasten auf, mit denen unterschiedliche Funktionen des Sicherheitssystems aktiviert oder deaktiviert werden können.

Das Zuhaltemodul kann, da dessen Submodule an diesem in zwei um 180° gedrehten Drehpositionen montiert werden können, seinerseits in zwei um 180° gegeneinander gedrehten Drehpositionen eingesetzt werden, wobei in beiden Drehpositionen die Submodule dieselbe Anordnung aufweisen. Damit kann ein und dasselbe Zuhaltemodul für die Aufnahme eines rechtsseitigen und eines linksseitigen Griffmoduls dienen, wodurch mit einem geringen konstruktiven Aufwand zwei Varianten des Sicherheitssystems realisiert werden können. Gemäß einer vorteilhaften Weiterbildung der Erfindung weist das Funktionsmodul Anschlussmodule zum Anschluss weiterer Module auf, wobei die Anschlussmodule als Stecker oder Buchsen ausgebildet sind.

Damit kann das Zuhaltemodul zu einer modular aufgebauten Modulanordnung erweitert werden. Vorteilhaft bilden die Anschlussmodule ein modulares System, wobei die Anschlussmodule austauschbar an dem Funktionsmodul oder den weiteren Modulen montierbar sind.

Damit kann die Modulanordnung besonders flexibel ausgebildet werden.

Die Erfindung wird im Folgenden anhand der Zeichnungen erläutert. Es zeigen:
- Figur 1:: Zwei Varianten eines Sicherheitssystems mit einem Zuhaltemodul und einem zugeordneten Griffmodul.
- Figur 2:: Zuhaltemodul gemäß Figur 1 in einer ersten Drehposition
- Figur 3:: Zuhaltemodul gemäß Figur 1 in einer zweiten Drehposition.
- Figur 4:: Leiterplatte für das Zuhaltemodul der Figuren 1 bis 3.
- Figur 5:: Ausführungsform eines Steckers als Anschlussmodul für das Zuhaltemodul der Figuren 1 bis 3.
- Figur 6:: Erste Variante einer Buchse als Anschlussmodul für das Zuhaltemodul der Figuren 1 bis 3.
- Figur 7:: Zweite Variante einer Buchse als Anschlussmodul für das Zuhaltemodul der Figuren 1 bis 3.

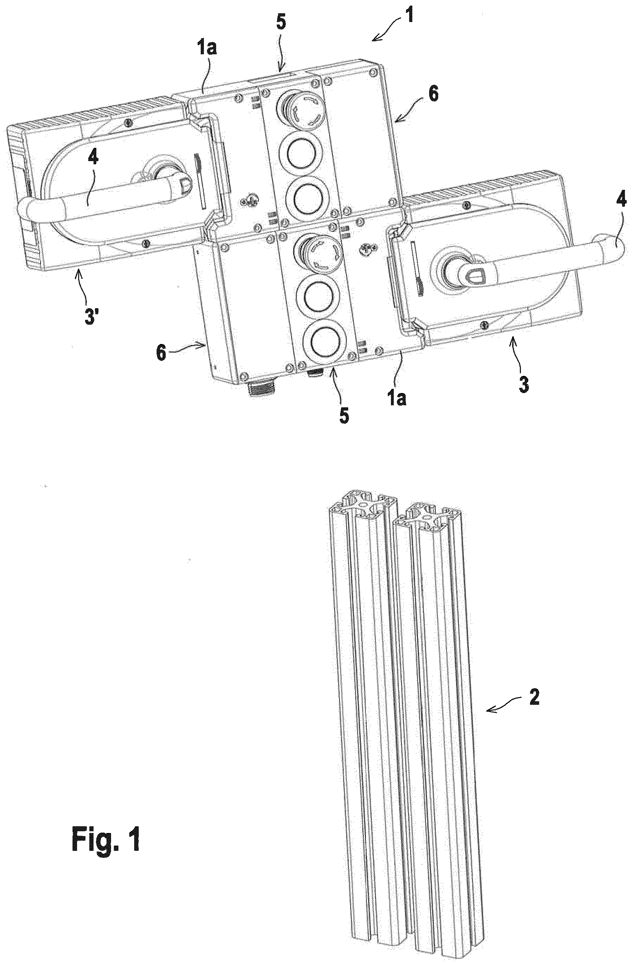

Figur 1 zeigt ein Ausführungsbeispiel des erfindungsgemäßen Funktionsmoduls in Form eines Zuhaltemoduls 1. Das Zuhaltemodul 1 ist Bestandteil eines Sicherheitssystems, spezifisch eines Sicherheitszuhaltesystems. Das Zuhaltemodul 1 kann, wie Figur 1 zeigt, in zwei um 180° gegeneinander gedrehten Drehpositionen eingesetzt werden und in diesen Drehpositionen an einer Profilschiene 2 befestigt werden. In der ersten Drehposition des Zuhaltemoduls 1 ist an diesem ein rechtsseitiges Griffmodul 3 angeordnet. In der zweiten Drehposition des Zuhaltemoduls 1 ist an diesem ein linksseitiges Griffmodul 3' angeordnet. Jedes Griffmodul 3, 3' weist einen Türdrücker 4 auf.

Das Zuhaltemodul 1 und das Griffmodul 3, 3' bilden eine Funktionseinheit, die ein sicheres Zuhalten einer Schutztür oder dergleichen gewährleistet. Der Türdrücker 4 kann prinizipiell mit einer Federkraft in zugehaltener Stellung gehalten und durch Magnetkraft entsperrt werden. Im vorliegenden Fall wird der Türdrücker 4 mittels einer Magnetkraft, die mittels eines im Zuhaltemodul 1 angeordneten Magneten erzeugt wird, in zugehaltener Stellung gehalten und durch eine Federkraft entsperrt.

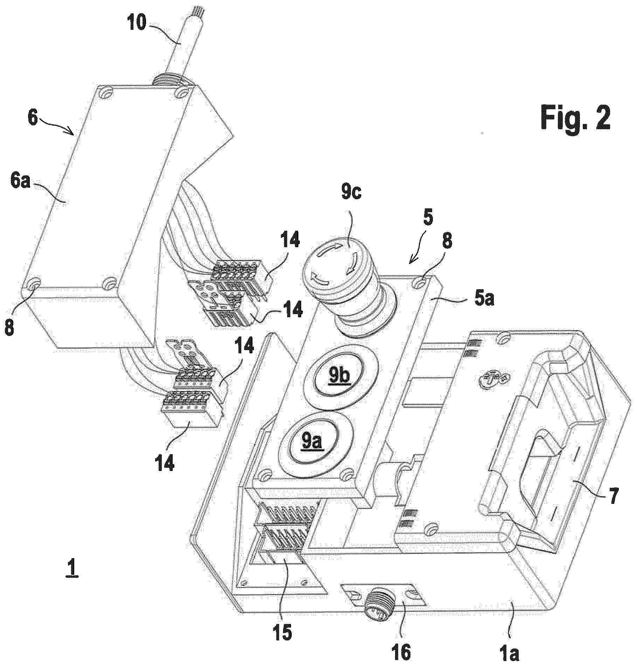

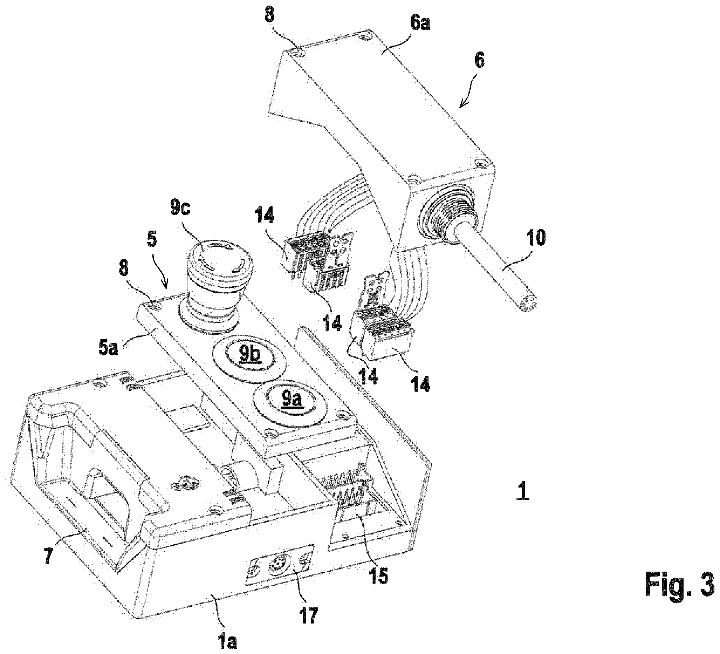

Das Zuhaltemodul 1 weist ein erstes Funktionsmodul in Form eines Tasten-Submoduls 5 und zweites Funktionsmodul in Form eines Anschluss-Submoduls 6 auf. Figur 1 zeigt die Submodule im jeweils eingebauten Zustand im Zuhaltemodul 1. Die Figuren 2 und 3 zeigen das Zuhaltemodul 1 in einer Einzeldarstellung mit jeweils abgenommenen Submodulen.

Dabei zeigt Figur 2 das Zuhaltemodul 1 in einer ersten Drehposition, in welcher eine Riegel-Aufnahme 7 an der rechten Seite zur Aufnahme des rechtsseitigen Griffmoduls 3 liegt. Figur 3 zeigt das Zuhaltemodul 1 in einer bezüglich der ersten Drehposition um 180° gedrehten zweiten Drehposition, in welcher die Riegel-Aufnahme 7 an der linken Seite zur Aufnahme des linksseitigen Griffmoduls 3' liegt.

Die Komponenten des Zuhaltemoduls 1 sind in einem Gehäuse 1a integriert. Wie die Figuren 2 und 3 zeigen, weist das Gehäuse 1a Aussparungen auf, die Aufnahmen für das Tasten-Submodul 5 und das Anschluss-Submodul 6 bilden. Das Tasten-Submodul 5 und das Anschluss-Submodul 6 weisen jeweils ein Gehäuseteil auf. Nach Einsetzen dieser Gehäuseteile in die Aussparungen ist das Gehäuse 1a des Zuhaltemoduls 1 vollständig geschlossen. Das Gehäuseteil des Tasten-Submoduls 5 ist in Form eines Tasten-Submodul-Deckels 5a ausgebildet. Das Gehäuseteil des Anschluss-Submoduls 6 ist in Form eines Anschlusssubmodulgehäuses 6a ausgebildet. Sowohl das Anschlusssubmodulgehäuse 6a als auch der Tasten-Submodul-Deckel 5a weisen Bohrungen 8 auf, durch welche nicht dargestellte Befestigungsschrauben geführt werden können, um diese am Gehäuse 1a zu befestigen.

Das Tasten-Submodul 5 weist als Bedienelemente für das Zuhaltemodul 1 mehrere Tasten 9a, 9b auf, insbesondere auch einen Nothalt-Taster 9c. Die Tasten 9a, 9b sind an der Frontseite des Tasten-Submodul-Deckels 5a vorgesehen. Das Anschluss-Submodul 6 dient zum Anschluss an externe Einheiten, wie beispielsweise ein externes Bussystem, und weist hierzu einen Kabelabgang 10 auf, der seitlich am Anschlusssubmodulgehäuse 6a ausmündet.

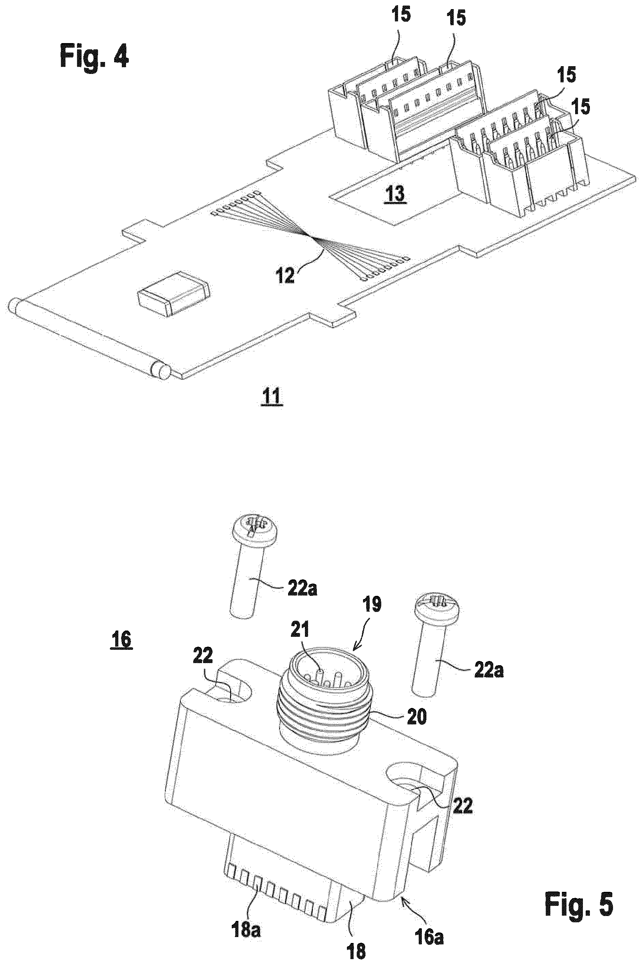

Im Innenraum des Zuhaltemoduls 1 ist eine Leiterplatte 11 angeordnet, die in Figur 4 in einer Einzeldarstellung gezeigt ist. In der Leiterplatte 11 verlaufen Busleitungen 12 eines Datenbusses, der im vorliegenden Fall als CAN-Bus ausgebildet ist. Der Datenbus bildet ein internes Bussystem, das unabhängig von externen Bussystemen arbeitet. Über den Datenbus erfolgt eine interne Kommunikation aller Komponenten des Zuhaltemoduls 1 und dessen Submodule. Die Leiterplatte 11 weist eine Ausnehmung 13 auf, in welche der Magnet zur Verriegelung des Griffmoduls 3 einsetzbar ist.

Erfindungsgemäß sind die Submodule, das heißt das Tasten-Submodul 5 und das Anschluss-Submodul 6, derart ausgebildet, dass diese jeweils in zwei um 180° gegeneinander gedrehten Drehpositionen am Zuhaltemodul 1 montiert werden können. Hierzu sind einerseits der Tasten-Submodul-Deckel 5a und das Anschlusssubmodulgehäuse 6a der Submodule drehsymmetrisch bezüglich einer Drehung um 180° ausgebildet. Desweiteren weisen beide Submodule auch elektrische Anschlussmittel zum Anschluss an Anschlussmittel des Zuhaltemoduls 1 auf, die ebenfalls drehsymmetrisch bezüglich einer Drehung um 180° sind.

Bei dem Tasten-Submodul 5 können die Anschlussmittel beispielsweise in Form von nicht dargestellten Federkontakten ausgebildet sein, die an der Unterseite des Tasten-Submodul-Deckels 5a angeordnet sind und mit ebenfalls nicht dargestellten Kontaktelementen der Leiterplatte 11 kontaktiert werden können.

Das Anschluss-Submodul 6 weist elektrische Anschlussmittel in Form von Anschlussklemmen 14 auf, die durch einfaches Aufstecken mit Anschlussteilen 15 auf der Leiterplatte 11 kontaktiert werden können, wobei diese Anschlussteile 15 in Form von Gegenstücken zu den Anschlussklemmen 14 ausgebildet sind.

Durch die Drehsymmetrie der Submodule können diese in beiden Drehpositionen des Zuhaltemoduls 1 so an diesem montiert werden, dass die Submodule in beiden Drehpositionen des Zuhaltemoduls 1 exakt dieselbe Lage bezüglich einer Unterlage wie der Profilschiene 2 aufweisen.

Das erfindungsgemäße Zuhaltemodul 1 kann auf eine Modulanordnung mit mehreren Modulen erweitert werden. Hierzu können an gegenüberliegenden Seiten des Gehäuses 1a des Zuhaltemoduls 1 Anschlussmodule integriert werden, die in Form von Steckern 16 oder Buchsen 17 ausgebildet sind.

Die Modulanordnung kann dann aus mehreren Zuhaltemodulen 1 bestehen. Generell können als Module auch separate Anschlussmodule oder Tastenmodule angeschlossen werden. Zweckmäßig verläuft die Kommunikation aller Module über den Datenbus, wobei die einzelnen Module über die Anschlussmodule an diesen Datenbus angeschlossen sind.

Die Figuren 5 bis 7 zeigen in Detaildarstellungen die Ausbildung der Anschlussmodule für das Zuhaltemodul 1 der Figuren 1 bis 3. Figur 5 zeigt eine Ausführungsform eines Steckers 16. Der Stecker 16 weist einen Stecker-Grundkörper 16a auf, an dessen Unterseite die Kontaktschnittstelle 18 ausmündet. Die Kontaktschnittstelle 18 weist Federkontakte 18a auf, mittels derer eine Kontaktierung an Kontaktpads der Leiterplatte 11 im Zuhaltemodul 1 erfolgen kann. An der Oberseite mündet ein Anschlusselement 19 aus, das im vorliegenden Fall eine genormte M12-Schnittstelle ausbildet. Das Anschlusselement 19 ist hohlzylindrisch ausgebildet und weist an seiner Außenseite ein Außengewinde 20, im vorliegenden Fall ein M12-Gewinde auf. Im Inneren des Anschlusselements 19 verlaufen mehrere Kontaktstifte 21. Der Stecker-Grundkörper 16a weist seitlich zwei Befestigungsbohrungen 22 auf, durch welche Schrauben 22a geführt werden können um so den Stecker 16 am Zuhaltemodul 1 zu fixieren.

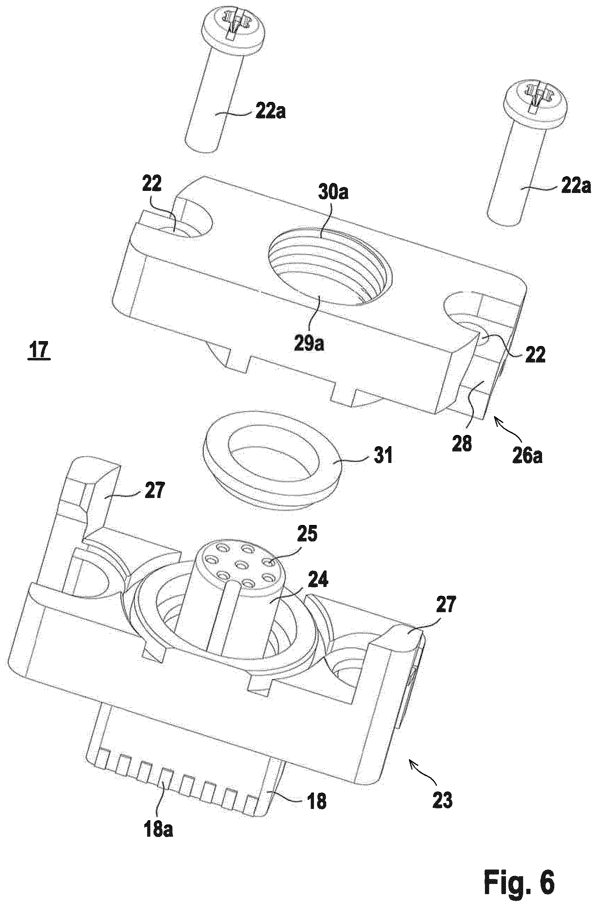

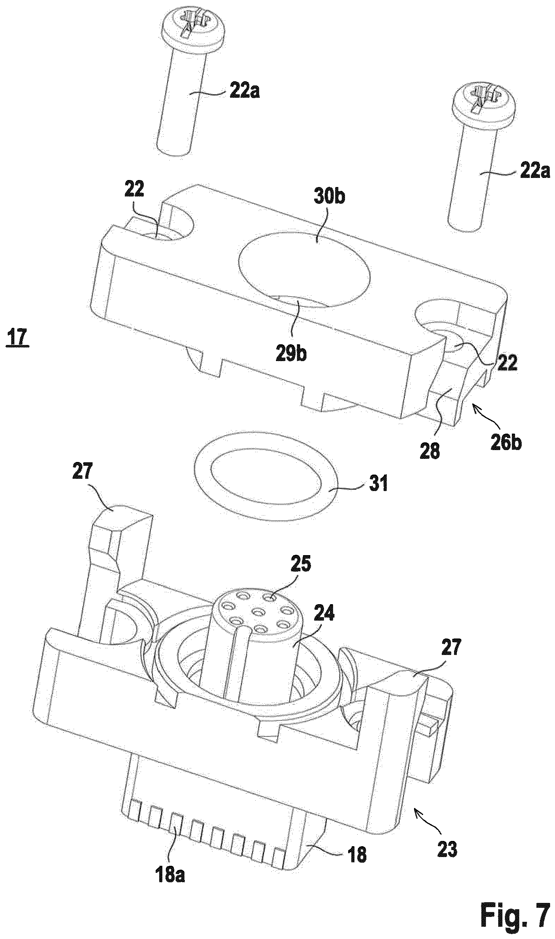

Dem Stecker 16 gemäß Figur 5 sind zwei Varianten einer Buchse 17 zugeordnet, welche in den Figuren 6 und 7 dargestellt sind. Die Buchse 17 weist einen für beide Varianten identischen Grundkörper 23 auf, an dessen Unterseite, entsprechend der Ausbildung des Steckers 16, die Kontaktschnittstelle 18 mit den Federkontakten 18a vorgesehen ist. An der Oberseite des Grundkörpers 23 befindet sich ein zylindrisches Anschlussteil 24 mit Kontaktelementen 25 in Form von Kontaktbohrungen, in welche die Kontaktstifte 21 des Steckers 16 eingesteckt werden.

Zur Ausbildung zweier unterschiedlicher Buchsen-Varianten sind dem Grundkörper 23 zwei verschiedene Aufsätze 26a, 26b zugeordnet, die in den Figuren 6 und 7 dargestellt sind. Beide Aufsätze 26a, 26b weisen dieselbe Außenkontur auf, so dass wahlweise einer der Aufsätze 26a, 26b auf den Grundkörper 23 aufgesetzt werden kann. Zur Lagefixierung dieser Teile weist der Grundkörper 23 Vorsprünge 27 auf, die auf komplementär hierzu ausgebildete Ausnehmungen 28 in den Aufsätzen 26a, 26b aufgesetzt werden können. Weiterhin weisen die Aufsätze 26a, 26b analog zum Stecker 16 seitlich wie Befestigungsbohrungen 22 auf, in welche Schrauben 22a eingeführt werden können, um die Buchse 17 am Zuhaltemodul 1 oder an einem weiteren Modul fixieren zu können.

Die Aufsätze 26a, 26b unterscheiden sich hinsichtlich der Ausbildung zentraler Bohrungen 29a, 29b, die bei auf dem Grundkörper 23 aufgesetzten Aufsatz 26a, 26b das Anschlussteil 24 des Grundkörpers 23 mit Spiel umschließen. Die Bohrung 29a des Aufsatzes 26a wird durch ein Innengewinde 30a begrenzt, während die Bohrung 29b des Aufsatzes 26b durch ein glattes Wandelement 30b des Aufsatzes 26a, 26b begrenzt ist.

Der entsprechende Aufsatz 26a, 26b wird mit einer Dichtung 31 in Form eines O-Rings auf den Grundkörper 23 zur Ausbildung der Buchse 17 aufgesetzt.

Entsprechend der unterschiedlich ausgebildeten Bohrungen 29a, 29b werden Buchsen 17 mit unterschiedler Funktionalität erhalten. In die Buchse 17 mit dem Aufsatz 26a gemäß Figur 6 können Kabelstecker und dergleichen eingeschraubt werden. Demgegenüber wird die Buchse 17 mit dem Aufsatz 26b gemäß Figur 7 auf den Stecker 16 gemäß Figur 5 aufgesteckt, wobei dann das die Bohrung 29a umschließende Wandelement 30b das Anschlusselement 19 des Steckers 16 mit geringem Spiel umschließt.

### Bezugszeichenliste

- (1): Zuhaltemodul
- (1a): Gehäuse
- (2): Profilschiene
- (3, 3'): Griffmodul
- (4): Türdrücker
- (5): Tasten-Submodul
- (5a): Tasten-Submodul-Deckel
- (6): Anschluss-Submodul
- (6a): Anschlusssubmodulgehäuse
- (7): Riegel-Aufnahme
- (8): Bohrung
- (9a, 9b): Taste
- (9c): Nothalt-Taster
- (10): Kabelabgang
- (11): Leiterplatte
- (12): Busleitung
- (13): Ausnehmung
- (14): Anschlussklemme
- (15): Anschlussteil
- (16): Stecker
- (16a): Stecker-Grundkörper
- (17): Buchse
- (18): Kontaktschnittstelle
- (18a): Federkontakt
- (19): Anschlusselement
- (20): Außengewinde
- (21): Kontaktstift
- (22): Befestigungsbohrung
- (22a): Schrauben
- (23): Grundkörper
- (24): Anschlussteil
- (25): Kontaktelement
- (26a, 26b): Aufsatz
- (27): Vorsprung
- (28): Ausnehmung
- (29a, 29b): Bohrung
- (30a): Innengewinde
- (30b): Wandelement
- (31): Dichtung

## Patentansprüche

1. Funktionsmodul mit einem Gehäuse, wobei das Gehäuse wenigstens eine Aufnahme für ein Submodul ausbildet, wobei das Funktionsmodul Bestandteil eines Sicherheitszuhaltesystems ist, und wobei das Submodul in zwei unterschiedlichen Drehpositionen in der Aufnahme montierbar ist, wobei das Submodul drehinvariante elektrische Anschlussmittel derart aufweist, dass diese in den beiden Drehpositionen des Submoduls in identischer Weise mit elektrischen Anschlussmitteln im Gehäuse des Funktionsmoduls kontaktiert werden können, **dadurch gekennzeichnet, dass** das Funktionsmodul ein Zuhaltemodul (1) eines Sicherheitssystems ist wobei am Gehäuse des Zuhaltemoduls (1) eine seitlich ausmündende Riegel-Aufnahme (7) für ein Griffmodul (3) vorgesehen ist und wobei in einer ersten Drehposition des Zuhaltemoduls (1) an der Riegel-Aufnahme (7) ein rechtsseitiges Griffmodul (3) montierbar ist, und dass in einer um 180° bezüglich der ersten Drehposition gedrehten zweiten Drehposition des Zuhaltemoduls (1) an der Riegel-Aufnahme (7) ein linksseitiges Griffmodul (3') fixierbar ist.

2. Funktionsmodul nach Anspruch 1, **dadurch gekennzeichnet, dass** das Submodul in zwei um 180° gegeneinander gedrehten Drehpositionen in der Aufnahme montierbar ist.

3. Funktionsmodul nach Anspruch 1 oder 2, **dadurch gekennzeichnet, dass** die Anschlussmittel im Gehäuse an einen Datenbus angeschlossen sind.

4. Funktionsmodul nach Anspruch 3, **dadurch gekennzeichnet, dass** Busleitungen (12) des Datenbusses in einer im Gehäuse angeordneten Leiterplatte (11) verlaufen.

5. Funktionsmodul nach einem der Ansprüche 1 bis 4, **dadurch gekennzeichnet, dass** dieses ein Anschluss-Submodul (6) als Submodul aufweist.

6. Funktionsmodul nach einem der Ansprüche 1 bis 5, **dadurch gekennzeichnet, dass** dieses ein Tasten-Submodul (5) als Submodul aufweist.

7. Funktionsmodul nach einem der Ansprüche 2 bis 6, **dadurch gekennzeichnet, dass** die Anschlussmittel als steckbare Anschlussklemmen ausgebildet sind.

8. Funktionsmodul nach einem der Ansprüche 1 bis 7, **dadurch gekennzeichnet, dass** als Anschlussmittel Federkontakte vorgesehen sind.

9. Funktionsmodul nach einem der Ansprüche 1 bis 8, **dadurch gekennzeichnet, dass** dieses Anschlussmodule zum Anschluss weiterer Module aufweist, wobei die Anschlussmodule als Stecker (16) oder Buchsen (17) ausgebildet sind.

10. Funktionsmodul nach Anspruch 9, **dadurch gekennzeichnet, dass** die Anschlussmodule ein modulares System bilden, wobei Anschlussmodule austauschbar an dem Funktionsmodul oder den weiteren Modulen montierbar sind.

## Claims

1. Functional module with a housing, wherein the housing forms at least one receptacle for a sub-module, wherein the functional module is a component of a safety retaining system, wherein the sub-module can be mounted in two different rotational positons in the receptacle and wherein the sub-module has rotationally invariant electrical connecting means of such a kind that in the two rotational positions of the sub-module these can be contacted in identical manner with electrical connecting means in the housing of the functional module, **characterised in that** the functional module is a retaining module (1) of a safety system, wherein a laterally opening locking receptacle (7) for a grip module (3) is provided at the housing of the retaining module (1) and wherein a righthand grip module (3) can be mounted at the locking receptacle (7) in a first rotational position of the retaining module (1) and a lefthand grip module (3') is fixable to the locking receptacle (7) in a second rotational position, which is turned through 180° with respect to the first rotational position, of the retaining module (1).

2. Functional module according to claim 1, **characterised in that** the sub-module can be mounted in the receptacle in two rotational positions turned through 180° relative to one another.

3. Functional module according to claim 1 or 2, **characterised in that** the connecting means in the housing is connected with a data bus.

4. Functional module according to claim 3, **characterised in that** bus conductors (12) of the data bus run in a circuitboard (11) arranged in the housing.

5. Functional module according to any one of claims 1 to 4, **characterised in that** this comprises a connecting sub-module (6) as sub-module.

6. Functional module according to any one of claims 1 to 5, **characterised in that** this comprises a button sub-module (5) as sub-module.

7. Functional module according to any one of claims 2 to 6, **characterised in that** the connecting means are constructed as pluggable connecting terminals.

8. Functional module according to any one of claims 1 to 7, **characterised in that** spring contacts are provided as connecting means.

9. Functional module according to any one of claims 1 to 8, **characterised in that** this comprises connecting modules for connection of further modules, wherein the connecting modules are formed as plugs (16) or bushes (17).

10. Functional module according to claim 9, **characterised in that** the connecting modules form a modular system, wherein connecting modules can be exchangeably mounted on the functional module or the further modules.

## Revendications

1. Module fonctionnel doté d'un boîtier, lequel boîtier forme au moins un réceptacle destiné à un sous-module, ledit module fonctionnel faisant partie intégrante d'un système de verrouillage de sécurité et ledit sous-module pouvant être monté, dans ledit réceptacle, en deux emplacements différents pris par rotation, lequel sous-module est pourvu de moyens de connexion électrique à invariance rotatoire, de façon telle que ces derniers puissent être mis en contact de manière identique, aux deux emplacements dudit sous-module pris par rotation, avec des moyens de connexion électrique dans le boîtier dudit module fonctionnel, **caractérisé par le fait que** ledit module fonctionnel est un module de verrouillage (1) d'un système de sécurité, sachant qu'un logement de pêne (7), débouchant latéralement et dévolu à un module de poignée (3), est prévu sur le boîtier dudit module de verrouillage (1), et sachant qu'un module de poignée (3) de droite peut être monté dans ledit logement de pêne (7) en un premier emplacement dudit module de verrouillage (1) pris par rotation ; et **par le fait qu'**un module de poignée (3') de gauche peut être bloqué à demeure, dans ledit logement de pêne (7), en un second emplacement dudit module de verrouillage (1) résultant d'une rotation de 180° par rapport audit premier emplacement pris par rotation.

2. Module fonctionnel selon la revendication 1, **caractérisé par le fait que** le sous-module peut être monté dans le réceptacle en deux emplacements pris par rotation de 180° l'un par rapport à l'autre.

3. Module fonctionnel selon la revendication 1 ou 2, **caractérisé par le fait que** les moyens de connexion sont raccordés à un bus de données dans le boîtier.

4. Module fonctionnel selon la revendication 3, **caractérisé par le fait que** des lignes (12) du bus de données s'étendent dans une plaquette (11) à circuits imprimés, logée dans le boîtier.

5. Module fonctionnel selon l'une des revendications 1 à 4, **caractérisé par le fait que** ce dernier comporte un sous-module de connexion (6), en tant que sous-module.

6. Module fonctionnel selon l'une des revendications 1 à 5 **caractérisé par le fait que** ce dernier comporte un sous-module (5) à touches, en tant que sous-module.

7. Module fonctionnel selon l'une des revendications 2 à 6, **caractérisé par le fait que** les moyens de connexion sont réalisés sous la forme de bornes enfichables de connexion.

8. Module fonctionnel selon l'une des revendications 1 à 7, **caractérisé par le fait que** des contacts à ressorts sont prévus en tant que moyens de connexion.

9. Module fonctionnel selon l'une des revendications 1 à 8, **caractérisé par le fait que** ce dernier comporte des modules de connexion dévolus au raccordement de modules supplémentaires, lesdits modules de connexion étant réalisés sous la forme de fiches (16) ou de prises (17).

10. Module fonctionnel selon la revendication 9, **caractérisé par le fait que** les modules de connexion forment un système modulaire, des modules de connexion pouvant être montés, de manière interchangeable, sur ledit module fonctionnel ou sur les modules supplémentaires.
